# EUROPEAN PATENT SPECIFICATION

(11) **EP 2 618 135 B1**
(45) Date of publication and mention of the grant of the patent: **03.07.2019**
(21) Application number: 13150231.2
(22) Date of filing: 04.01.2013
(51) Int. Cl.: G01N 21/956, H05K 13/08

(54) **Method for registering inspection standard for soldering inspection and board inspection apparatus thereby**
Verfahren zur Registrierung des Prüfstandards für Lötprüfungen und Plattenprüfvorrichtung damit
Procédé d'enregistrement de norme d'inspection pour l'inspection de soudure et appareils d'inspection de panneau

(30) Priority: 17.01.2012 JP 2012006877
(43) Date of publication of application: 24.07.2013
(73) Proprietor: Omron Corporation, Kyoto Kyoto 600-8530 (JP)
(72) Inventor: Fujii, Shinpei, Kyoto 600-8530 (JP); Kawai, Naohiro, Kyoto 600-8530 (JP); Konda, Ryuichiro, Kyoto 600-8530 (JP); Yoshida, Masaomi, Kyoto 600-8530 (JP)
(74) Representative: Horn Kleimann Waitzhofer Patentanwälte PartG mbB

(56) References cited:
- EP-A2- 1 568 985
- WO-A1-2012/098697
- JP-A- 2006 220 437
- JP-A- 2008 032 525
- JP-B2- 3 275 631
- US-A1- 2004 101 190
- US-A1- 2006 271 226

## Description

### BACKGROUND OF THE INVENTION

### 1. TECHNICAL FIELD

The present invention relates to a board inspection apparatus that measures a three-dimensional shape of a solder fillet on a board (hereinafter referred to as a "component mounting board"), to which a component is already soldered, and performs a soldering inspection whether the solder fillet is defective based on a measurement result of the three-dimensional shape of the solder fillet. Particularly, the present invention relates to a technology of registering an inspection standard for the soldering inspection. Hereinafter, sometimes the solder fillet is simply referred to as a "fillet".

### 2. RELATED ART

For example, Japanese Patent Publication No. 6-1173 discloses an inspection apparatus for soldering inspection, in which an inspection with a system called a color highlight system is performed. The color highlight system inspection apparatus includes a lighting device that emits a red light beam, a green light beam, and a blue light beam from directions different from one another and a color camera that images regularly-reflected light of each color light beam. A color region corresponding to each color light beam in the image is extracted by a threshold set in each color light beam, and whether a slope state of the solder fillet is defective is determined based on whether a feature amount, such as an area and a position of the color region, are fit to a predetermined determination standard (see Japanese Patent No. 4389801).

There is also developed an inspection apparatus having a function of measuring the three-dimensional shape of the fillet by applying a principle of an optical system of the above disclosed inspection apparatus (see Japanese Unexamined Patent Publication Nos. 2010-71844 and 2010-71782). In the apparatus disclosed in Japanese Unexamined Patent Publication No. 2010-71844, in the image of the fillet of the inspection target, a measurement line is set along a direction in which the color regions corresponding to each of the color light beams are arrayed in the order of a lighting angle range, a boundary value of a slope angle range detected by each color light beam is applied to a boundary position between the color regions on the measurement line, a approximate curve expressing a slope state of the fillet is specified, and a risen level of the solder by wetting is obtained by integration of the approximate curve.

The apparatus disclosed in Japanese Unexamined Patent Publication No. 2010-71782 includes a dome-shaped lighting device and a stereo camera, a normal direction to a pixel corresponding to the solder in the image is measured in each camera, and the pixels are correlated with each other between the cameras based on the normal direction to measure a solder level.

As described in Japanese Patent No. 4389801, in the conventional color highlight system inspection apparatus, the inspection is performed by the method of processing a distribution pattern or a feature amount of the color region in the image. However, it is not easy for a user who is not familiar with this kind of inspection to comprehend a relationship between the fillet shape and the color distribution in the image, and thus difficult to set the inspection standard. There is also a demand by some users that they want to express the quality of the board that is guaranteed by the inspection with a fixed numerical value when shipping the board that passed the inspection.

JP 2008032525 discloses a setting method of inspection reference data for visual examination of substrate and visual examination device of substrate using it.

US 2004/0101190 A1 discloses a characteristic amount calculating device for soldering inspection.

### SUMMARY

The present invention has been devised to solve and meet the problems and the demand of the users described above, and an object thereof is to perform the inspection based on a specific shape of a solder fillet and to be able to easily set the standard of the inspection. Solution is provided by a method according to claim 1, and by an apparatus according to claim 2.

Aboard inspection apparatus to which the present invention is applied performs a soldering inspection including imaging a component mounting board to which a plurality of components are soldered under lighting from a plurality of directions, measuring a three-dimensional shape of a solder fillet of each component using a generated image, and performing the defective determination of the solder fillet based on a measurement result. In accordance with an aspect of the present invention, an inspection standard registering method includes repeating a step of displaying a setting screen and a step of receiving an input of a numerical value to an input field to one component on the board of the inspection target or a group including a plurality of identical kind of components, while the target component being changed, in order to set a standard of an inspection for defective determination of a numerical parameter expressing the three-dimensional shape of the solder fillet with respect to the target component, the setting screen including a list of a plurality of inspection items, each item name thereof being correlated with an input field of a standard value used for defective determination of a numerical parameter measured by the respective inspection items, and an image of the component of a setting target. The method further includes setting the inspection item to which the standard value is input in each setting screen to the item that should be performed in the inspection of the component corresponding to the setting screen, setting the numerical value input in each inspection item to the standard value of the defective determination, and producing inspection standard data by a combination of the inspection item and the standard value, and registering a set of the pieces of the produced inspection standard data in the board inspection apparatus.

According to the method, the user checks the target component to which the inspection standard is set from the image on the setting screen, and input the standard value of the defective determination of the numerical parameter measured in the inspection item in each inspection item necessary for the soldering inspection of the target component. According to the method, the setting can intuitively be set based on the shape of the real fillet, which facilitates the setting operation.

According to one embodiment of the method, the method further includes, when a manipulation to select one of the inspection items in the setting screen for the purpose of reference while the setting screen is displayed, displaying a reference diagram in which a concept of the parameter measured by the selected inspection item is expressed by an image expressing a shape of solder to the component of the processing target in a place that is not overlapped with the display of the currently-selected inspection item.

According to the embodiment, when one inspection item is selected on the selection screen for the purpose of reference, the reference diagram in which the concept of the parameter measured by the selected inspection item is visually expressed is displayed. Therefore, the operator can recognize what kind of data is measured by the selected inspection item or the shape or size of the measurement target site, enabling to input the proper setting value.

In accordance with another aspect of the present invention, a board inspection apparatus includes: a display part that displays a setting screen in order to set an inspection standard for the soldering inspection; a manipulation part that is used to manipulate the setting screen; a manipulation receiving part that repeatedly performs a step of displaying a setting screen and a step of receiving a manipulation to input a numerical value to an input field to one component on the board of the inspection target or a group including a plurality of identical kind of components, while the target component being changed, the setting screen including a list of a plurality of inspection items according to an inspection for defective determination of a numerical parameter expressing the three-dimensional shape of the solder fillet with respect to the target component, each item name being correlated with an input field of a standard value used for defective determination of a numerical parameter measured by the respective inspection items, and an image of the component of a setting target; an inspection standard data producing part that sets the inspection item to which the standard value is input in each setting screen to the item that should be performed in the inspection of the component corresponding to the setting screen, sets the numerical value input in each inspection item to the standard value of the defective determination, and produces inspection standard data by a combination of the inspection item and the standard value; and a registration part that registers a set of the pieces of the produced inspection standard data in the inspection standard data producing part. According to the configuration, the inspection can be started after the inspection standard registering method is performed.

According to the present invention, the specific numerical value expressing the shape of the real solder fillet is registered as the standard value used in the defective determination, so that the operation to register the inspection standard is facilitated. Also, the numerical value used for the inspection standard can clearly express what kind of quality being guaranteed.

### BRIEF DESCRIPTION OF THE DRAWINGS

FIG. 1 is a block diagram illustrating a configuration example of a board inspection apparatus;
FIG. 2 is a view illustrating a principle to measure a level of a solder fillet;
FIGS. 3A and 3B are views illustrating a setting example of a measurement line in FIG. 2;
FIG. 4 is a flowchart illustrating a procedure of teaching processing;
FIG. 5 is a view illustrating an example of a setting screen on which a model image is registered;
FIG. 6 is a view illustrating an example of a setting screen on which an inspection standard of a soldering inspection is set;
FIG. 7 is a view illustrating a state in which a reference diagram is displayed on the inspection standard setting screen;
FIG. 8 is a view illustrating a state in which the reference diagram is displayed on the inspection standard setting screen;
FIG. 9 is a view illustrating a state in which the reference diagram is displayed on the inspection standard setting screen;
FIG. 10 is a view illustrating a state in which the reference diagram is displayed on the inspection standard setting screen;
FIG. 11 is a view illustrating an example of a setting screen on which an inspection standard of a component inspection is set; and
FIG. 12 is a view illustrating an example of a screen displaying a test inspection result.

### DETAILED DESCRIPTION

Hereinafter, preferred embodiments of the present invention will be described with reference to the drawings.

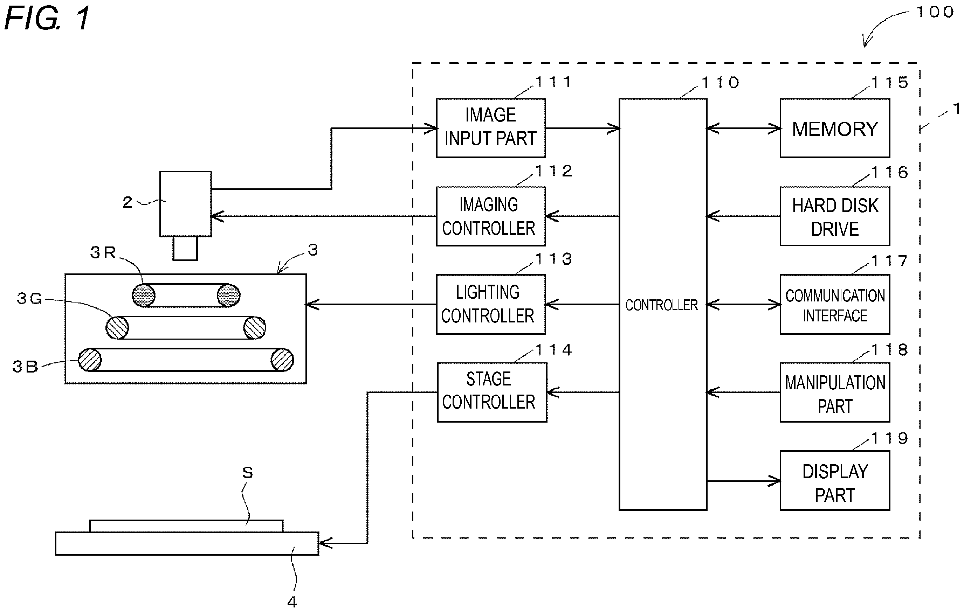

FIG. 1 illustrates a configuration of a board inspection apparatus according to an embodiment of the present invention. A board inspection apparatus 100 of the embodiment includes a control processor 1, a camera 2, a lighting device 3, and a board stage 4. The board stage 4 moves a board S in a direction along each side (an X-axial direction and a Y-axial direction) while supporting the board S of an inspection target in a horizontal attitude. The camera 2 generates a color image, and is fixed to a portion above the board stage 4 in an attitude in which an optical axis is oriented toward a substantially vertical direction (an attitude in which the camera faces a front surface of the board S on the stage 4).

The lighting device 3 is disposed between the camera 2 and the board stage 4. The lighting device 3 of the embodiment includes ring-like light sources 3R, 3G, and 3B that emit a red light beam, a green light beam, and a blue light beam. The light sources 3R, 3G, and 3B have diameters different from one another. The light sources 3R, 3G, and 3B are disposed while centers thereof are aligned with the optical axis of the camera 2. The red light source 3R having the smallest diameter is disposed uppermost, the blue light source 3B having the largest diameter is disposed lowermost, and the green light source 3G is disposed therebetween. With these dispositions of the light sources 3R, 3G, and 3B, each angle range of a light beam incident to the board S become different by colors, to generate an image in which a tilt state of a slope surface of solder on the board S is expressed by a distribution pattern of colors corresponding to each lighting.

Specifically, a red region generated by the red light beam having the smallest incident light angle range in the three colors indicates a gradual slope angle, and a blue region generated by the blue light beam having the largest incident light angle range indicates a significantly steep slope angle. A green region generated by the green light beam indicates a slope angle range between the slope angle range indicated by the red region and the slope angle range indicated by the blue region.

The lighting device 3 is not limited to the ring-like light source, but a lighting device having a configuration, in which three kinds of point light sources (for example, LEDs) are arrayed in a doom-shaped casing so as to implement the similar detection principle, may be used as the lighting device 3. Instead of the configuration in which the board stage 4 is moved in the X-axis direction and the Y-axis direction, the board stage 4 may be moved in one axial direction while the camera 2 is moved in the other axial direction.

The control processor 1 includes a controller 110 of a computer, an image input part 111, an imaging controller 112, a lighting controller 113, a stage controller 114, a memory 115, a hard disk drive 116, a communication interface 117, a manipulation part 118, and a display part 119. The controller 110 controls operations of the camera 2, the lighting device 3, and the board stage 4 through the imaging controller 112, the lighting controller 113, and the stage controller 114. The image generated by the camera 2 is input to the controller 110 after digitally converted at the image input part 111.

In addition to a program related to the control, image data and a calculation result of a processing target are temporarily stored in the memory 115. An inspection program group which will be described below, a measurement data and an inspection result which are obtained by the inspection, and an image used in the inspection are stored in the hard disk drive 116.

The communication interface 117 conducts communication with another device through a LAN line (not illustrated). The manipulation part 118 is constructed by a mouse and a keyboard, and used to set various settings before the inspection, and the like. The display part 119 displays a setting screen before the inspection, and displays the inspection result of each time and the image used in the inspection when the inspection is started.

The inspection apparatus 100 of the embodiment focuses attention on a component on the board S to inspect existence or non-existence, a misalignment, a proper or improper orientation (polarity) of the component. A solder fillet is inspected with a method such that, after levels of plural points on the fillet are measured using the color region distribution generated by the lighting, a numerical parameter expressing a three-dimensional shape of the fillet is acquired by the calculation using each measured value and whether a value of the parameter is proper is determined.

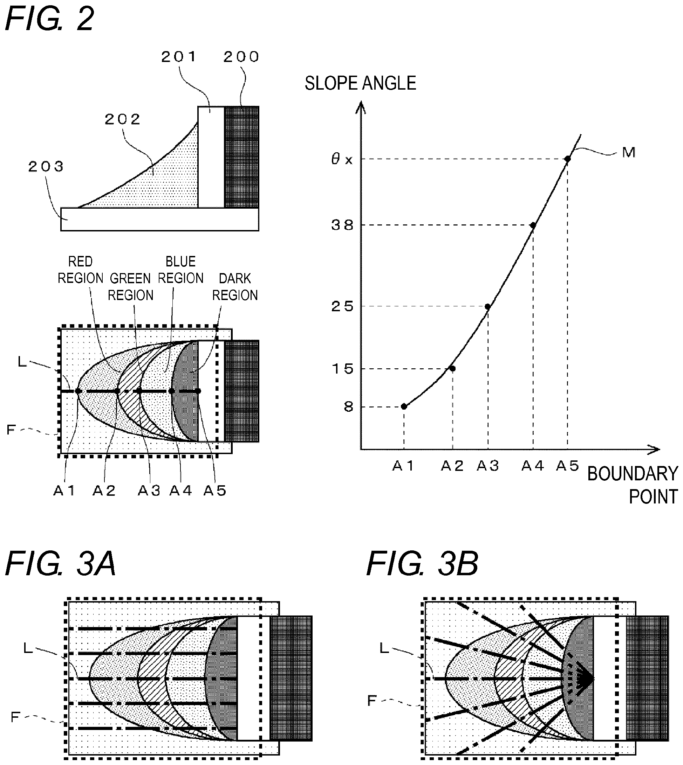

A principle to obtain the level data of the fillet will be described with reference to FIGS. 2 and 3. FIG. 2 illustrates the principle to measure the level data of the fillet with a chip component as an example. A schematic diagram illustrating a fillet 202 connecting an electrode 201 and a land 203 of a chip component 200 and a schematic diagram illustrating the image that is obtained by imaging the fillet 202 correspond vertically to each other on the left side of FIG. 2. In the schematic diagram of the image, each color region is respectively replaced with a painting pattern.

As illustrated in FIG. 2, in the image generated by an optical system of the embodiment, along the direction from a place near an outside end edge of the land 203 in the image toward the component electrode 201, the color regions of regularly-reflected light images of the color light beams emerge in the ascending order of the slope angle range (that is, in the order of red, green, and blue). In the case that the steep slope surface exceeding the slope angle range corresponding to the blue region exists near the component 200, the steep slope surface emerges in the image as a dark region where the regularly-reflected light image does not exist.

In the embodiment, using the feature of the image, an inspection region F is set in each land, where a direction in which the red, green, and blue color regions are arrayed is found, and a measurement line L is set along the direction. A point A1 at an end edge outside the red region and points A2, A3, and A4 located at a boundary between each color region are extracted in the measurement line L. An intersection A5 of the measurement line L and the end edge of the component electrode 201 is extracted.

To each extracted point except the point A5, the slope angle corresponding to each point is applied. While each of the slope angles in the places where the red, green, and blue color regions emerge has a certain level of width, it is considered that a boundary position between the color regions adjacent to each other indicates an angle near the boundary value of the slope angle ranges indicated by the respective color regions. Accordingly, the angle of the boundary between the slope angle ranges indicated by the respective color regions can be applied to the boundary position between the color regions.

In the example in FIG. 2, it is assumed that the slope angle range indicated by the red region ranges from 8 to 15 degrees, that the slope angle range indicated by the green region ranges from 15 to 25 degrees, and that the slope angle range indicated by the blue region ranges from 25 to 38 degrees. The point A1 is applied with 8 degrees, the point A2 is applied with 15 degrees, the point A3 is applied with 25 degrees, and the point A4 is applied with 38 degrees. As illustrated in a graph on the right in FIG. 2, an approximate curve M expressing a change in slope angle along the measurement line L is derived based on a relationship between the angles applied to the points A1 to A4 and coordinates at the points A1 to A4 in the image.

Attention is focused in turn on each point in the range, from the point A1 to the point A5 of the approximate curve M, and the solder level at focused point is calculated by integration of the curve of the change in slope angle from the point A1 to the focused point. Therefore, the change in level can be obtained on one line along the slope of the fillet 202. Hereinafter, the line indicating the change in level is referred to as a "slope line".

In the embodiment, as illustrated in FIGS. 3A and 3B, the plural measurement lines L are set in the inspection region F, and the same processing as the above is performed to each measurement line L, thereby obtaining the plural slope line. The measurement line L may be set by either of the method in FIG. 3A or the method in FIG. 3B, and more measurement lines L than those shown in FIGS. 3A and 3B are set. A length and a width of the fillet 202, a wetting rise level of the solder to the component electrode 201, and wetting angles to the land 203 and the component electrode 201 are measured using the level data and the X- and Y-coordinates at each point included in the slope line. The numerical parameter is a specific numerical value expressing the shape of the fillet 202. The soldering inspection is performed through processing of calculating the parameters and processing of comparing the calculated parameter to previously-registered standard value.

For the purpose of the inspection, an inspection program produced in each kind of the board is registered in the hard disk drive 116 of the inspection apparatus 100. The inspection program includes a component kind, a component number, positional information, and inspection standard data of each component on the board. The inspection standard data includes an inspection item performed in each inspection region and a standard value that is used to check the parameter obtained by the measurement in the inspection, in addition to the setting data of the inspection region.

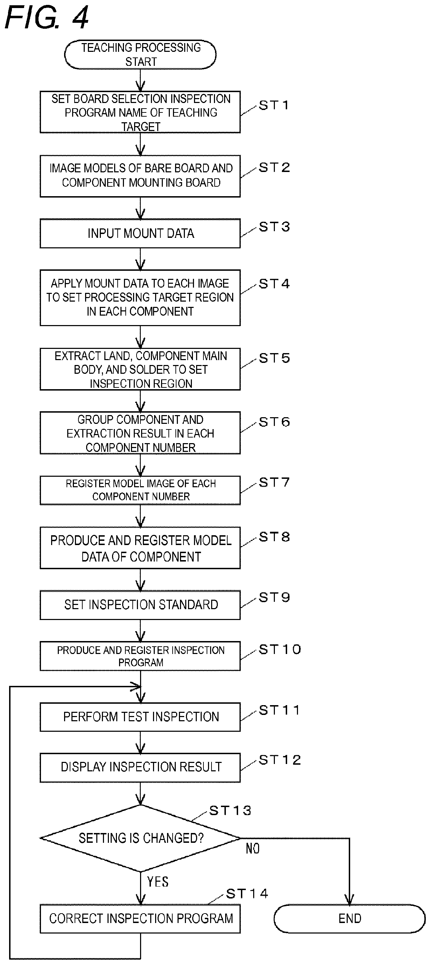

FIG. 4 illustrates a procedure of teaching processing that is performed when the inspection program of the board of the new inspection target is registered. The controller 110 in FIG. 1 mainly performs the teaching processing while receiving a setting manipulation of a user.

In a first Step ST1, the controller 110 displays a list of previously-registered board names on the display part 119, and receives a manipulation to select the board of the teaching target. After the board is selected, an inspection program name is continuously set. The name of the board of the teaching target is used as the inspection program name. The inspection program name may be changed by the user manipulation.

In Step ST2, a model of the real board is imaged. In the embodiment, it is assumed that two kinds of the models are prepared for the board of the teaching target. One of the models is the component mounting board that is completed through each process of a solder printing process, a component mounting process by a mounter, and a reflow process, and the other model is the printed wiring board (hereinafter referred to as a "bare board") before the above three processes are performed. In Step ST2, the two kinds of the boards are imaged and the generated images are captured. The imaging is not limited to Step ST2. For example, the image produced by the previous imaging may be stored in and called from the hard disk drive 116.

In Step ST3, mount data (including the component kind of the mounting component, the part number, identification information characteristic for the component, and the positional information) used in the component mounting process are input. In Step ST4, a mounting range of each component in the image is recognized by applying the mount data to each image captured in Step ST2. A processing target region is set in each component based on the recognition result.

In Step ST5, attention is focused in turn on the processing target region to extract the land, the component main body, and the solder, and the inspection region is set in each extracted site. In the extraction processing in Step ST5, at first the land is extracted by separating the color of the land from the other color (a base color of the board) in the image of the bare board. Then the extraction result of the image of the bare board is checked against the component mounting board image, and the place in which the color is changed different from the land is extracted as the solder in the component mounting board image. The change in color generated in the range surrounded by the land is extracted as those corresponding to the component.

In Step ST6, the component in which the extraction is ended and the extraction result are grouped in each component number. The user can check the grouping result by calling the grouping result on the display part 119 in each component number.

In Step ST7, a model image of each component number is registered based on the grouping result. Specifically, attention is focused in turn on each component number to display the image of each component belonging to the component number, the user is caused to select at least one image, and the selected image is registered as the model image.

In Step ST8, using the registered model image, the model data expressing the component feature, such as the color and the size of the component main body, are produced and registered in each component number. In Step ST9, the setting manipulation performed by the user is received while the component image used as the model image is displayed, and inspection standard data is set in each inspection region. At this point, the setting data of the inspection region is also included in the inspection standard data. In Step ST10, an inspection program in which the inspection standard data and pieces of information on the component of the mount data are bundled is produced and registered in the hard disk drive 116.

Then, according to the manipulation to start a test inspection performed by the user, the test inspection is performed to the component mounting board image captured in Step ST2 using the set inspection standard data, and the inspection result is displayed (Steps ST11 and 12). When the user determines that the inspection standard data needs to be corrected and changes the setting (YES in Step ST13), the inspection program is corrected in accordance with the change (Step ST14). The test inspection and the display are repeated until the user determines that the displayed inspection result is proper. When the user determines that the inspection result is proper (NO in Step ST13), the inspection program is confirmed.

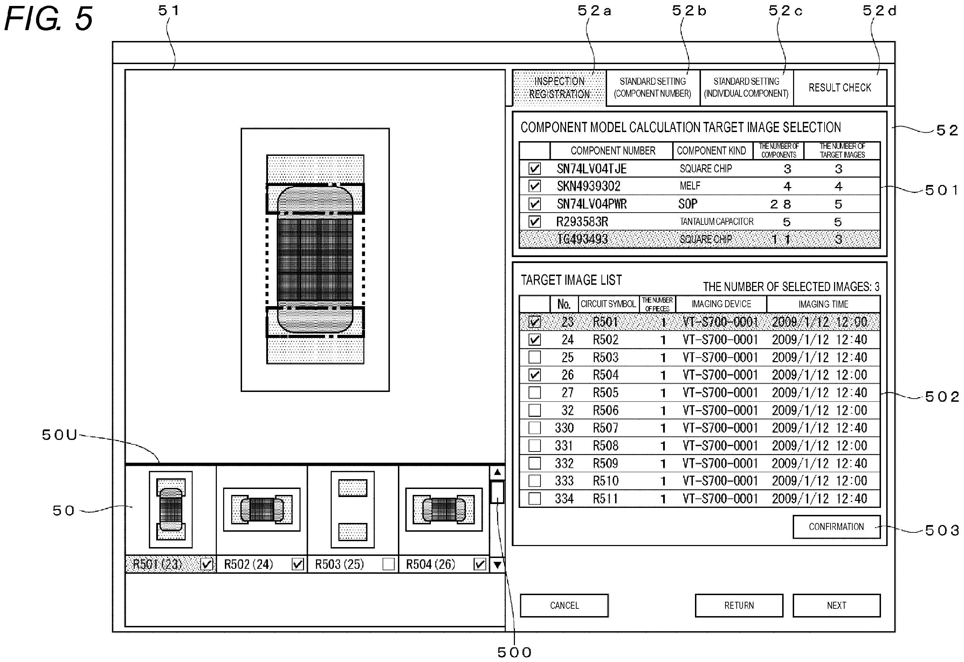

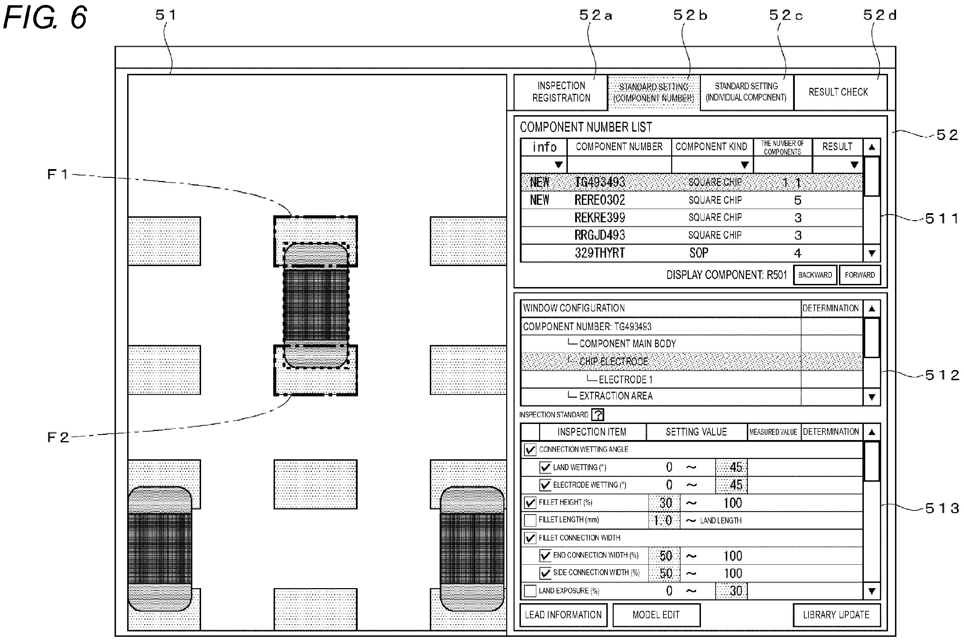

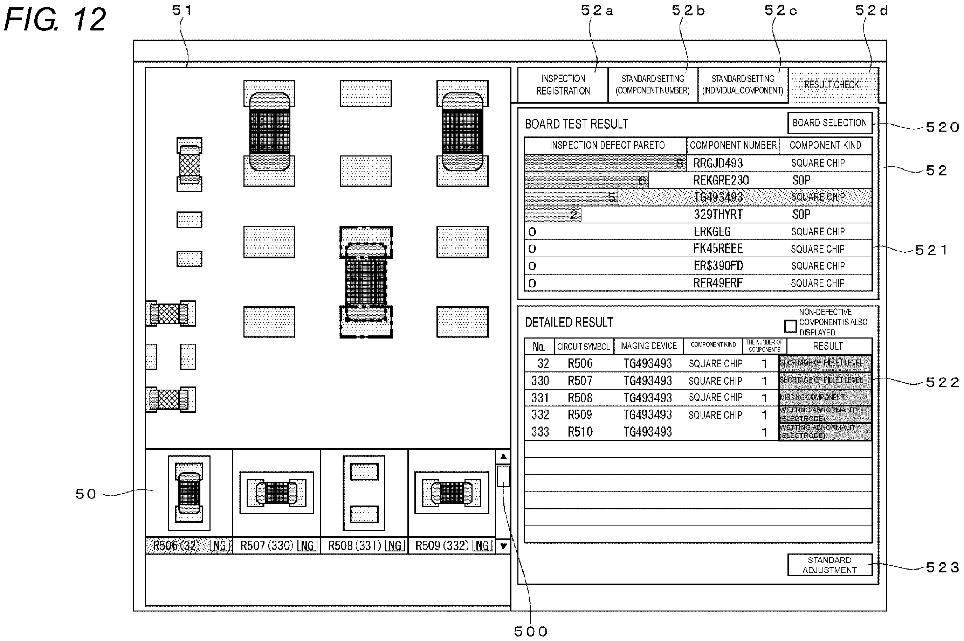

FIG. 5 illustrates an example of a setting screen in the model image registration processing (Step ST6) in the teaching processing, and FIGS. 6 to 11 illustrate examples of the setting screen in the inspection standard setting processing (Step ST9). FIG. 12 illustrates an example of the screen on which the result of the test inspection is displayed. In the progress of the processing, these screens are switched by the user manipulation or automatically switched.

A screen configuration common to each example will be described below. The screen is horizontally divided into two, and the component mounting board image (a part of the image captured in Step ST2) is displayed in a left region 51. Hereinafter, the region 51 is referred to as an "image display region 51".

Four tabs 52a, 52b, 52c, and 52d to which an "inspection registration", a "standard setting (component number)", a "standard setting (individual component)", and a "result check" are attached are overlapped in a right region 52. A list and buttons are set in each of the tabs 52a to 52d according to a setting content, and the tab of the display target is switched according to the progress of the work. Hereinafter, the region 52 in which the tabs 52a to 52d are displayed is referred to as a "tab region 52".

The screen (see FIG. 5) on which the tab 52a of the "inspection registration" is displayed is used in the pieces of processing in Steps ST3 to ST7 in FIG. 4. The screen in FIG. 5 is displayed in order to select the image that is used as the model image in Step ST7. In the tab 52a, a component number list 501 of the components mounted on the board and a component list 502 in which the components belonging to the component numbers selected in the list 501 are vertically arrayed. A horizontally-long, small window 50 is overlapped in the lower portion of the image display region 51, and the images of each component included in the component list 502 are displayed in four horizontal row in the small window 50.

In the small window 50, the subsequent component images can be displayed by a scroll bar 500 at a right end. An upper end edge 50U of the window 50 is pulled up by a drag manipulation, which allows the window 50 to be extended. In the component list 502 and the small window 50, the component information displayed in the central portion of the image display region 500 is distinguished by the highly bright color.

To the component of the embodiment, two kinds of identification codes (a component number and a circuit symbol) are set. In each partition of the component list 502 and the small window 50, a checkbox (no reference sign) is provided together with the identification code. When the user performs a manipulation to select the checkbox or a manipulation to release the selection of the checkbox in one of the component list 502 and the small window 50, the checkbox in the other of the component list 502 and the small window 50 is brought to the same state. The user selects the image, which is used to produce the model data, by the manipulation performed to the checkbox. In the model board, because the place where the component is missing or the component in the defective mounting state exists like the second example from the right in the window 50, the user selects at least one component in the good mounting state while checking the image display.

When the component selection is ended to manipulate a confirmation button 503 provided below the component list 502, the image of the selected component is registered as the model image used in the following setting. The pieces of model data, such as the component and the electrode size of the component, which are necessary for the inspection related to the component main body, are produced through the processing in the foregoing Step ST8 using the model image.

When the registration of the model image is ended with respect to each component number, the display in the tab region 52 is switched to the tab 52b of the "standard setting (component number)" as illustrated in FIG. 6. The display is switched to the screen on which the inspection standard is set in a unit of the component number, and a component configuration list 512 and an inspection standard list 513 are displayed in the tab region 52 in addition to the component number list 511.

The site, which corresponds to the component of the component number currently selected in the component number list 511 and becomes the inspection target, is displayed in the component configuration list 512 (a field of a "window configuration") together with the relationship between the component number and the component. A list of inspection items that can be performed to the site selected in the component configuration list 512 is displayed in the inspection standard list 513 together with the checkbox (no reference sign). These inspection items correspond to the kinds of the parameters, which are obtained using the level data of the aforementioned fillet. In the fields of the inspection items, a "connection wetting angle" includes "land wetting" and "electrode wetting" therebelow. Similarly, a "fillet connection width" includes an "end connection width" and a "side connection width" therebelow.

A field of a "setting value" is provided in the list of inspection items, and a numerical range is displayed in order to determine whether the parameter obtained by the inspection is defective. An upper limit and a lower limit of the numerical range are initially set to default values, and one (the numerical value indicated by a halftone pattern in FIG. 6) of the upper limit and the lower limit are set so as to be able to be changed. Similarly, the other numerical value is put into the state, in which the numerical value can be changed, by a click manipulation. The selection state of the checkbox is also set to a default.

In the image display region 51, the image in which one of the components registered as the model image with respect to the currently-selected component number is centered is displayed, and inspection regions F1 and F2 corresponding to the sites selected in the component configuration list 512 is expressed by thick frames. While referring to the image in the image display region 51 and the component kind of the component number list 52, the user determines the inspection item that he/she needs to inspect, and changes the selection state of the checkbox. The user also determines whether the setting value is suitable to the selected inspection item, and changes the numerical value as needed.

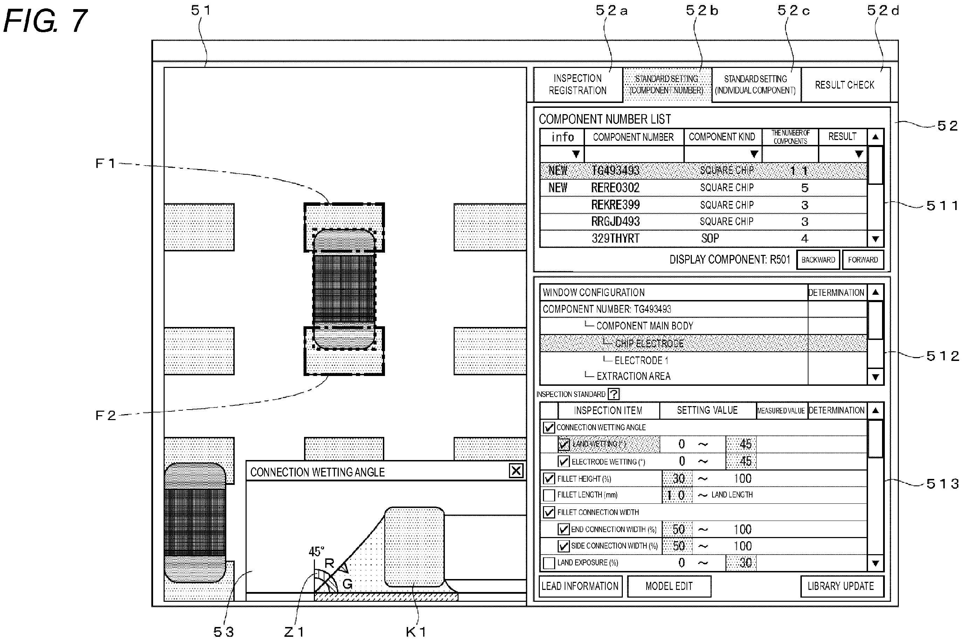

When the user points a mouse cursor to one of the inspection items to perform the click manipulation, a small window 53 emerges on the left (the lower portion of the image display region 51) of the tab region 52 to display a reference diagram related to the manipulated item as illustrated in FIGS. 7 to 11. The reference diagram illustrates a concept of the parameter that is measured in the currently selected and displayed inspection item using schematic diagrams K1 to K4 of the fillet of the inspection target.

Specifically, in each of the schematic diagrams K1 to K4, gauges Z1 to Z4 each of which expresses the range corresponding to the numerical value in which the corresponding parameter can be taken are illustrated while painted in green and red (in the drawings, the green is replaced with a diagonal-line pattern G, and the red is replaced with a pattern R along a gauge width). The green range means a numerical range (a numerical range determined to be non-defective) expressed by the upper limit and the lower limit, which are currently set in the inspection standard list 513, and the red means a range (a range determined to be defective) that is out of the non-defective numerical range. When the numerical value of the inspection standard list 513 is changed, the green and red ranges in the gauge K also vary.

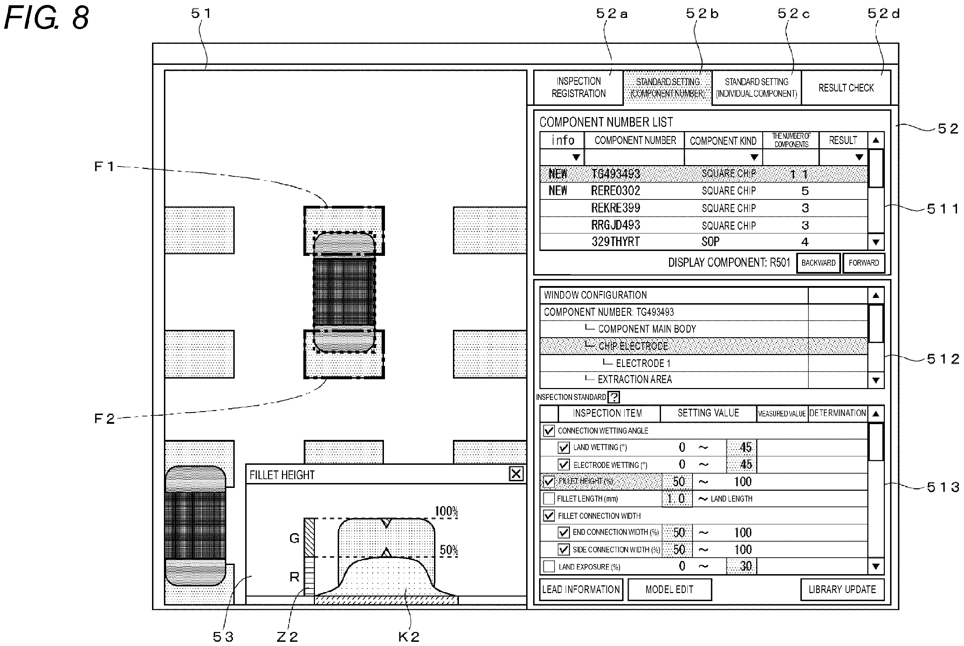

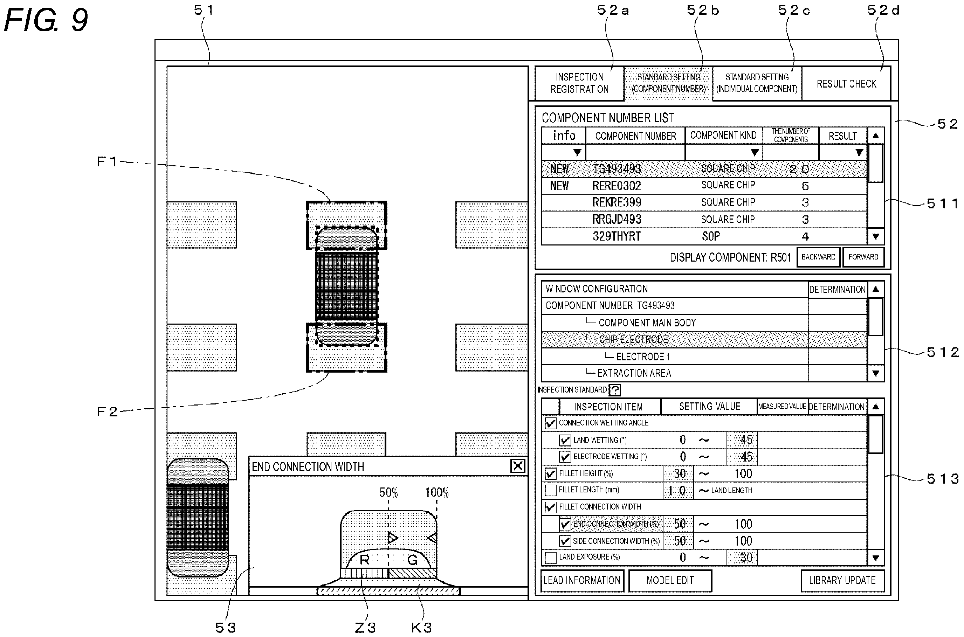

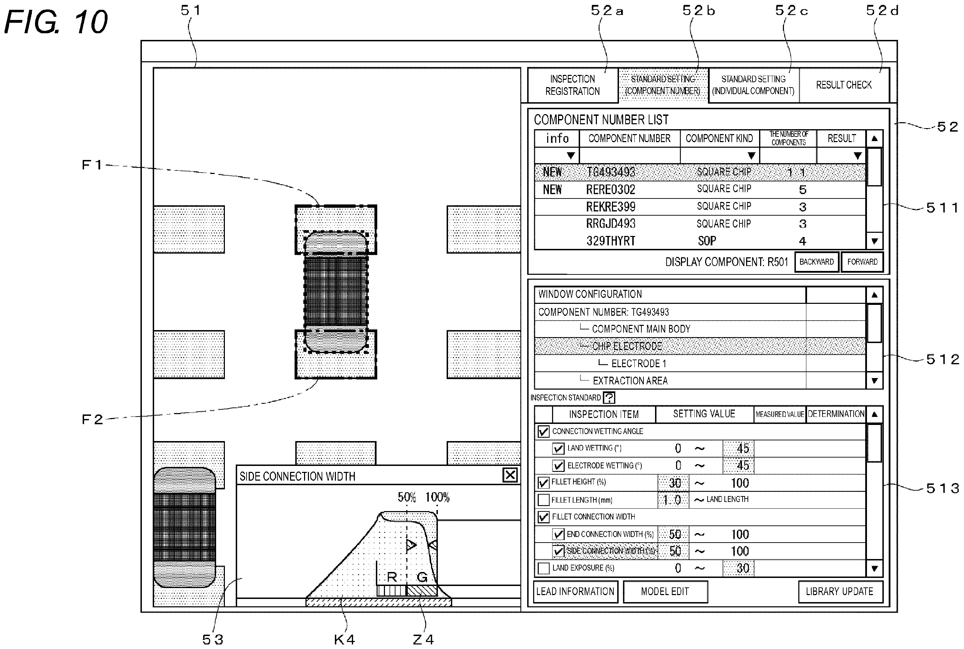

The schematic diagrams K1 to K4 are sectional views illustrating the state in which the solder fillet and the component are partially cut at the place where the identification of the determination target is easily distinguished. For example, in the schematic diagram K1 in FIG. 7, a solder wetting angle (a land wetting angle) to the land is expressed using the sectional view along a long side (a lengthwise direction of the fillet) of the component main body. In the schematic diagram K2 in FIG. 8, a wetting rise level of the fillet is expressed using the sectional view illustrating the state in which the place near the component main body of the fillet is cut along a short side of the component main body. In the schematic diagram K3 in FIG. 9, a solder width (the end connection width) near the end edge of the fillet is expressed using the sectional view illustrating the state in which the place near the end edge of the fillet is cut along the short side of the component main body. In the schematic diagram K4 in FIG. 10, a solder width (the side connection width) that is in contact with the surface of the long side is expressed using the sectional view illustrating the state in which the place near the long side of the component main body is cut along the long side of the component main body.

When the user changes the setting value of the selection item corresponding to the schematic diagram while the schematic diagrams K1 to K4 are displayed, the green and red paintings are also changed in the gauges G1 to G4 in the drawings.

Thus, the place of the measurement target is schematically expressed in each inspection item together with the concept of the parameter obtained by the measurement and the range determined to be non-defective, so that the user who does not know the content of the inspection item can easily understand its content.

The user specifies the item to be inspected and the standard value of the defective determination used in the inspection by the selection of the checkbox in the inspection standard list 513 and the input of the setting value. The inspection item in which the checkbox is in the selection state becomes effective, and incorporated in the inspection program together with the set standard value. The inspection item that is kept in the default setting is also certified by the user and dealt with as being selected and input.

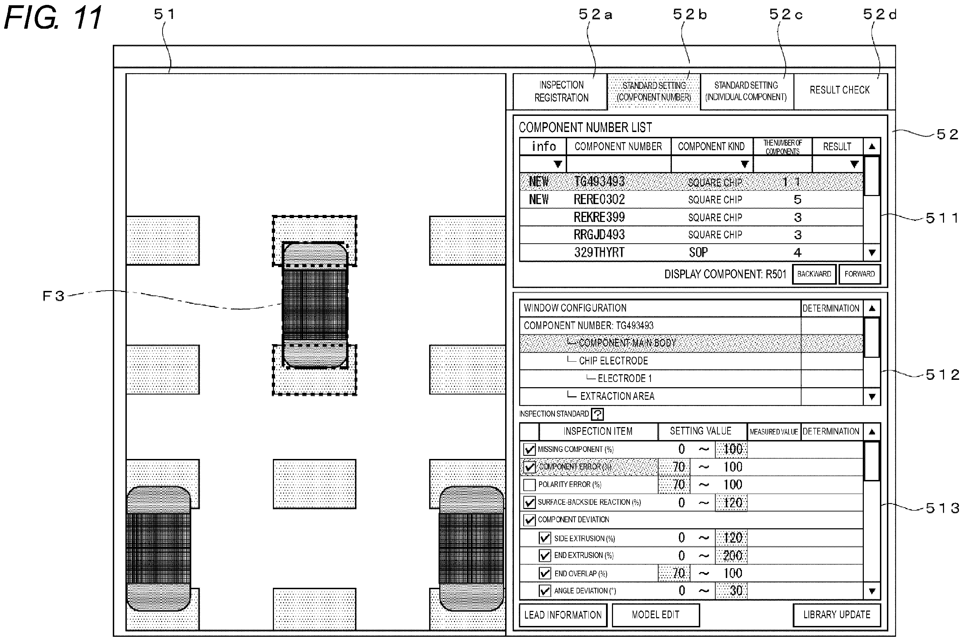

FIG. 11 illustrates an example of the screen on which the inspection standard for the component inspection is set. In this case, the inspection item for the component inspection is displayed in the inspection standard area 513 together with the selection checkbox and the setting value. The user selects the item to be inspected, and changes the upper limit or the lower limit of the field of "setting value" as needed.

Although not illustrated in the drawings, also for the setting of the component inspection, the reference diagram illustrating the concept of the parameter processed in the inspection item is displayed in the image display region 51 by the manipulation to click the name of the inspection item.

In the component inspection, the numerical range indicated in the field of "setting value" is not limited to the range determined to be non-defective, but the numerical range may indicate the range determined to be defective depending on the inspection item. For example, in the uppermost "missing component", a ratio of an area of the place that does not agree with the color of the component indicated by the model data in the inspection region is measured, and the determination of the missing component (the state in which the component does not exist) is made when the measured value of the ratio is included in the numerical range of the field of "setting value".

In FIGS. 6 to 11, by way of example, the tab 52b of the "standard setting (component number)" is selected, and the inspection standard is set in the unit of component number. Alternatively, the tab 52c of the "standard setting (individual component)" is selected, and the inspection standard to which the mounting state of the component or a surrounding environment is added may be set in each component. Although not illustrated in the drawings, the inspection standard can be set in each individual board in the case that a board having a structure in which plural individual boards having the same configuration are continued is set to the teaching target.

In an example in FIG. 12, the tab 52d of the "result check" is selected in the tab region 52. The tab 52d is used to designate the performance of the test inspection or to display the inspection result. In the tab 52d, a button 520 is provided in an upper end portion in order to issue an instruction to perform the test inspection, and two kinds of lists 521 and 522 are vertically disposed below the button 520.

When the button 520 is manipulated after the inspection standard is set on the screens in FIGS. 6 to 11, the inspection program is produced in Step S10 in FIG. 4, the test inspection in Step ST11 is performed, and the inspection results are displayed in the lists 521 and 522. In the upper list 521, the number of defects is displayed in each component number using a bar graph. In the lower list 522, the information on the component, which is determined to be defective with respect to the component number selected in the list 521, is displayed together with the specific defective content. The information on the component determined to be non-defective can also be displayed in the list 522 as needed.

The small window 50 having the same configuration as the example in FIG. 5 is displayed in the left image display region 51, and the image of the component displayed in the list 522 is displayed in the small window 50.

A button 523 is provided below the list 522 in order to designate reset of the inspection standard. The user compares the inspection result in the list 522 to the image in the small window 50 to determine whether the inspection result is proper with respect to each component. When determining that the inspection result is improper, the user performs the manipulation to click the button 523. Thereby, the tab region 52 returns to the display used to set the inspection standard (see FIGS. 6 to 11), and the manipulation to change the inspection standard is received.

As described above, in the inspection apparatus 100 of the embodiment, the soldering inspection is performed by the method for obtaining the numerical parameter specifically expressing the shape of the fillet, and the inspection standard can be set by the manipulation to select the parameter (the inspection item) to be measured and the manipulation to set the determination standard value (the numerical value in the field of "setting value" of the inspection standard list 513 in FIG. 6) for the selected parameter. Therefore, the user can easily fix the standard based on the specific shape of the fillet. Quality of the board can clearly be expressed using the parameter value obtained by the performed inspection item.

In the inspection apparatus 100 of the embodiment, the color image generated by the optical system of the color highlight system is processed by the method in FIG. 2 to generate the level data of the solder. However, not limited thereto, and, for example, the three-dimensional shape of the fillet can also be measured in detail by the optical system disclosed in Japanese Unexamined Patent Publication No. 2010-71782. In this case, in the teaching processing, the component that is selected in registering the model image is measured, and the reference diagram in which the sectional view of the fillet based on the measurement result is illustrated together with the parameter value obtained by measurement can be produced and displayed.

## Claims

1. A method for registering inspection standard data that is of a standard for a defective determination of a solder fillet in a board inspection apparatus (100), the board inspection apparatus (100) performing an soldering inspection including imaging a component mounting board (S) to which a plurality of components are soldered under lighting from a plurality of directions, measuring a three-dimensional shape of a solder fillet of each component using a generated image, and performing the defective determination of the solder fillet based on a measurement result, the method including:
repeating a step of displaying a setting screen and a step of receiving, from a user, input of a numerical value to an input field to one component on the board (S) of the inspection target or a group including a plurality of identical kind of components, while the target component is changed, in order to set a standard of an inspection for defective determination of a numerical parameter expressing the three-dimensional shape of the solder fillet with respect to the target component, the setting screen including a list of a plurality of inspection items, each item name thereof being correlated with an input field of a standard value used for defective determination of a numerical parameter measured by the respective inspection items, and an image of the component of a setting target;
setting the inspection item to which the standard value is input in each setting screen to the item that should be performed in the inspection of the component corresponding to the setting screen, setting the numerical value input in each inspection item to the standard value of the defective determination, and producing inspection standard data by a combination of the inspection item and the standard value;
registering a set of the pieces of the produced inspection standard data in the board inspection apparatus (100); and
when a manipulation has been performed to select one of the inspection items in the setting screen for the purpose of reference while the setting screen is displayed, displaying a reference diagram in which a concept of the parameter measured by the selected inspection item is expressed by an image expressing a shape of solder to the component of the processing target in a place that is not overlapped with the display of the currently-selected inspection item,
wherein, in the reference diagram, a gauge (Z1 to Z4) is shown that expresses a numerical range in which the numerical parameter is determined to be non-defective and a numerical range in which the numerical parameter is determined to be defective.

2. Aboard inspection apparatus (100) that performs a soldering inspection, in which a component mounting board (S) to which a plurality of components are soldered is imaged under lighting from a plurality of directions, a three-dimensional shape of a solder fillet of each component is measured using a generated image, and the defective determination of the solder fillet is performed based on a measurement result, the board inspection apparatus (100) comprising:
a display part (119) that displays a setting screen in order to set an inspection standard for the soldering inspection;
a manipulation part (118) that is used to manipulate the setting screen;
a manipulation receiving part that repeatedly performs a step of displaying a setting screen and a step of receiving a user's input of a numerical value to an input field to one component on the board (S) of the inspection target or a group including a plurality of identical kind of components, while the target component is changed, the setting screen including a list of a plurality of inspection items according to an inspection for defective determination of a numerical parameter expressing the three-dimensional shape of the solder fillet with respect to the target component, each item name being correlated with an input field of a standard value used for defective determination of a numerical parameter measured by the respective inspection items, and an image of the component of a setting target;
an inspection standard data producing part that sets the inspection item to which the standard value is input in each setting screen to the item that should be performed in the inspection of the component corresponding to the setting screen, sets the numerical value input in each inspection item to the standard value of the defective determination, and produces inspection standard data by a combination of the inspection item and the standard value; and
a registration part that registers a set of the pieces of the produced inspection standard data in the inspection standard data producing part,
the display part (119) being configured so as to display, when a manipulation has been performed to select one of the inspection items in the setting screen for the purpose of reference while the setting screen is displayed, a reference diagram in which a concept of the parameter measured by the selected inspection item is expressed by an image expressing a shape of solder to the component of the processing target in a place that is not overlapped with the display of the currently-selected inspection item,
wherein, in the reference diagram, a gauge (Z1 to Z4) is shown that expresses a numerical range in which the numerical parameter is determined to be non-defective and a numerical range in which the numerical parameter is determined to be defective.

## Patentansprüche

1. Verfahren zur Registrierung von Prüfstandarddaten, die einen Standard für eine Fehlerbestimmung einer Lötausbuchtung in einer Plattenprüfvorrichtung (100) angeben, wobei die Plattenprüfvorrichtung (100) eine Lötprüfung durchführt, welche ein Darstellen einer Bauteilmontageplatte (S), an welcher mehrere Bauteile verlötet sind, unter Verwendung einer Beleuchtung aus mehreren Richtungen, ein Messen einer dreidimensionalen Form einer Lötausbuchtung von jedem einzelnen Bauteil unter Verwendung eines erzeugten Bildes, und ein Durchführen der Fehlerbestimmung der Lötausbuchtung basierend auf einem Messergebnis, umfasst, wobei das Verfahren umfasst:
Wiederholen, während das Zielbauteil verändert wird, eines Schrittes des Anzeigens eines Einstellungsbildschirms und eines Schrittes des Empfangens von einem Benutzer, eine Eingabe eines numerischen Wertes in ein Eingabefeld zu einem Bauteil auf der Platte (S) des Prüfziels oder einer Gruppe umfassend mehrere identische Arten von Bauteilen, um einen Standard für eine Prüfung für die Fehlerbestimmung eines numerischen Parameters, welcher die dreidimensionale Form der Lötausbuchtung in Bezug auf das Zielbauteil ausdrückt, einzustellen, wobei der Einstellungsbildschirm eine Liste mehrerer Prüf-Items umfasst, wobei davon jeder Item-Name mit einem Eingabefeld eines Standardwertes, der für die Fehlerbestimmung eines numerischen Parameters verwendet wird, der durch das jeweilige Prüf-Item gemessen wird, und mit einem Bild des Bauteils eines Einstellungsziels korreliert wird;
Einstellen des Prüf-Items, zu welchem der Standardwert in jedem Einstellungsbildschirm eingegeben wird, zu dem Item, dass bei der Prüfung des Bauteils, welches dem Einstellungsbildschirm entspricht, durchgeführt werden soll, Einstellen des numerischen Wertes, der in jedem Prüf-Item eingegeben wird, zu dem Standardwert der Fehlerbestimmung, und Erzeugen von Prüfstandarddaten durch eine Kombination des Prüf-Items und des Standardwertes;
Registrieren einer Menge von Teilen der erzeugten Prüfstandarddaten in der Plattenprüfvorrichtung (100); und
wenn eine Manipulation durchgeführt wurde, um eines der Prüf-Items in dem Einstellungsbildschirm zu Referenzzwecken, während der Einstellungsbildschirm angezeigt wird, auszuwählen, Anzeigen eines Referenzdiagramms, in welchem ein Konzept des Parameters, der durch das ausgewählte Prüf-Item gemessen wird, durch ein Bild ausgedrückt wird, welches eine Form von Lot an dem Bauteil des verarbeitenden Ziels an einem Ort ausdrückt, welcher nicht mit der Anzeige des derzeitigen-ausgewählten Prüf-Items überlappt,
wobei, in dem Referenzdiagramm ein Maß (Z1 bis Z4) gezeigt ist, das einen numerischen Bereich ausdrückt, in welchem der numerische Parameter als nicht-fehlerhaft bestimmt wird, und einen numerischen Bereich ausdrückt, in welchem der numerische Parameter als fehlerhaft bestimmt wird.

2. Plattenprüfvorrichtung (100), welche eine Lötprüfung durchführt, in welcher eine Bauteilmontageplatte (S), an welcher mehrere Bauteile verlötet sind, unter Verwendung einer Beleuchtung aus mehreren Richtungen dargestellt wird, wobei eine dreidimensionale Form einer Lötausbuchtung von jedem einzelnen Bauteil unter Verwendung eines erzeugten Bildes gemessen wird, und wobei die Fehlerbestimmung der Lötausbuchtung basierend auf einem Messergebnis durchgeführt wird, wobei die Plattenprüfvorrichtung (100) umfasst:
ein Anzeigeteil (119), das einen Einstellungsbildschirm anzeigt, um einen Prüfstandard für die Lötprüfung einzustellen;
ein Manipulationsteil (118), das dazu verwendet wird, den Einstellungsbildschirm zu manipulieren;
ein Manipulationsempfangsteil, das wiederholt, während das Zielbauteil verändert wird, einen Schritt des Anzeigens eines Einstellungsbildschirms und einen Schritt des Empfangens einer Benutzereingabe eines numerischen Wertes in ein Eingabefeld zu einem Bauteil auf der Platte (S) des Prüfziels oder einer Gruppe umfassend mehrere identische Arten von Bauteilen, durchführt, wobei der Einstellungsbildschirm eine Liste mehrerer Prüf-Items gemäß einer Prüfung für die Fehlerbestimmung eines numerischen Parameters umfasst, der die dreidimensionale Form der Lötausbuchtung in Bezug auf das Zielbauteil ausdrückt, wobei jeder Item-Name mit einem Eingabefeld eines Standardwertes, welcher für Fehlerbestimmung eines numerischen Parameters verwendet wird, der durch das jeweilige Prüf-Item gemessen wird, und mit einem Bild des Bauteils eines Einstellungsziels korreliert wird;
ein Prüfstandarddatenerzeugungsteil, dass das Prüf-Item, zu welchem der Standardwert in jedem Einstellungsbildschirm eingegeben wird, zu dem Item einstellt, dass bei der Prüfung des Bauteils, welches dem Einstellungsbildschirm entspricht, durchgeführt werden soll, dass den numerischen Wert, der in jedem Prüf-Item eingegeben wird, zu dem Standardwert der Fehlerbestimmung einstellt, und dass Prüfstandarddaten durch eine Kombination des Prüf-Items und des Standardwertes erzeugt; und
ein Registrierungsteil, dass eine Menge von Teilen der erzeugten Prüfstandarddaten in dem Prüfstandarddatenerzeugungsteil registriert,
das Anzeigeteil (119), das dazu eingerichtet, wenn eine Manipulation durchgeführt wurde, um eines der Prüf-Items in dem Einstellungsbildschirm zu Referenzzwecken, während der Einstellungsbildschirm angezeigt wird, auszuwählen, ein Referenzdiagramm anzuzeigen, in welchem ein Konzept des Parameters, der durch das ausgewählte Prüf-Item gemessen wird, durch ein Bild auszudrücken, welches eine Form von Lot an dem Bauteil des verarbeitenden Ziels an einem Ort ausdrückt, welcher nicht mit der Anzeige des derzeitigen-ausgewählten Prüf-Items überlappt,
wobei, in dem Referenzdiagramm ein Maß (Z1 bis Z4) gezeigt ist, das einen numerischen Bereich ausdrückt, in welchem der numerische Parameter als nicht-fehlerhaft bestimmt ist, und einen numerischen Bereich ausdrückt, in welchem der numerische Parameter als fehlerhaft bestimmt ist.

## Revendications

1. Procédé pour l'enregistrement de données étalons d'inspection qui font partie d'un étalon pour une détermination de défaut d'un congé de brasure dans un appareil d'inspection de panneau (100), l'appareil d'inspection de panneau (100) effectuant une inspection de brasage incluant la formation d'une image d'un panneau de montage de composants (8) sur lequel une pluralité de composés sont soumis à un brasage sous éclairage à partir d'une pluralité de directions, la mesure d'une forme tridimensionnelle d'un congé de brasure de chaque composant à l'aide d'une image générée, et la réalisation de la détermination de défaut du congé de brasure sur la base d'un résultat de mesure, le procédé incluant :
la répétition d'une étape consistant afficher un écran de réglage et d'une étape consistant à recevoir, à partir d'un utilisateur, la saisie d'une valeur numérique dans un champ de saisie pour un composant sur le panneau (S) de la cible d'inspection ou un groupe incluant une pluralité de composants de même type, tandis que le composant cible est modifié, afin d'établir un étalon d'une inspection pour la détermination de défaut d'un paramètre numérique exprimant la forme tridimensionnelle du congé de brasure par rapport au composant cible, l'écran de réglage incluant une liste d'une pluralité d'éléments d'inspection, chaque nom d'élément de celle-ci étant corrélé avec un champ de saisie d'une valeur étalon utilisée pour la détermination de défaut d'un paramètre numérique mesuré par les éléments d'inspection respectifs, et une image du composant d'une cible de réglage ;
le réglage de l'élément d'inspection pour lequel la valeur étalon est saisie dans chaque écran de réglage sur l'élément qui devrait être effectué dans l'inspection du composant correspondant à l'écran de réglage, le réglage de la valeur numérique saisie dans chaque élément d'inspection sur la valeur étalon de la détermination de défaut, et la production de données étalons d'inspection par une combinaison de l'élément d'inspection et de la valeur étalon ;
l'enregistrement d'un ensemble des pièces des données étalons d'inspection produites dans l'appareil d'inspection de panneau (100) ; et
lors d'une manipulation destinée à sélectionner l'un des éléments d'inspection sur l'écran de réglage à des fins de référence alors que l'écran de référence est affiché, l'affichage d'un schéma de référence dans lequel un concept du paramètre mesuré par l'élément d'inspection sélectionné est exprimé par une image exprimant une forme de brasure pour le composant de la cible de traitement à un endroit qui ne se chevauche pas avec l'affichage de l'élément d'inspection actuellement sélectionné,
dans lequel, sur le schéma de référence, une jauge (Z1 à Z4) est indiquée laquelle exprime une plage numérique dans laquelle le paramètre numérique est déterminé comme étant non défectueux et une plage numérique dans laquelle le paramètre numérique est déterminé comme étant défectueux.

2. Appareil d'inspection de panneau (100) qui effectue une inspection de brasage, dans lequel on forme une image, sous éclairage à partir d'une pluralité de directions, d'un panneau de montage de composants (S) sur lequel une pluralité de composés sont soumis à un brasage, une forme tridimensionnelle d'un congé de brasure de chaque composant est mesurée à l'aide d'une image générée, et la détermination de défaut du congé de brasure est effectuée sur la base d'un résultat de mesure, l'appareil d'inspection de panneau (100) comprenant :
une partie d'affichage (119) qui affiche un écran de réglage afin de régler un étalon d'inspection pour l'inspection de brasage ;
une partie de manipulation (118) qui est utilisée pour manipuler l'écran de réglage ;
une partie de réception de manipulation qui effectue de manière répétée une étape consistant à afficher un écran de réglage et une étape consistant à recevoir une saisie d'un utilisateur d'une valeur numérique dans un champ de saisie pour un composant sur le panneau (S) de la cible d'inspection ou un groupe incluant une pluralité de composants de même type, tandis que le composant cible est modifié, l'écran de réglage incluant une liste d'une pluralité d'éléments d'inspection selon une inspection pour la détermination de défaut d'un paramètre numérique exprimant la forme tridimensionnelle du congé de brasure par rapport au composant cible, chaque nom d'élément étant corrélé avec un champ de saisie d'une valeur étalon utilisée pour la détermination de défaut d'un paramètre numérique mesuré par les éléments d'inspection respectifs, et une image du composant d'une cible de réglage ;
une partie de produit de données étalons d'inspection qui règle l'élément d'inspection pour lequel la valeur étalon est saisie dans chaque écran de réglage sur l'élément qui devrait être effectué dans l'inspection du composant correspondant à l'écran de réglage, règle la valeur numérique saisie dans chaque élément d'inspection sur la valeur étalon de la détermination de défaut, et produit des données étalons d'inspection par une combinaison de l'élément d'inspection et de la valeur étalon ; et
une partie d'enregistrement qui enregistre un ensemble des pièces des données étalons d'inspection produites dans la partie de production de données étalons d'inspection,
la partie d'affichage (119) étant configurée de sorte à afficher, lors d'une manipulation destinée à sélectionner l'un des éléments d'inspection sur l'écran de réglage à des fins de référence alors que l'écran de référence est affiché, un schéma de référence dans lequel un concept du paramètre mesuré par l'élément d'inspection sélectionné est exprimé par une image exprimant une forme de brasure pour le composant de la cible de traitement à un endroit qui ne se chevauche pas avec l'affichage de l'élément d'inspection actuellement sélectionné,
dans lequel, sur le schéma de référence, une jauge (Z1 à Z4) est indiquée laquelle exprime une plage numérique dans laquelle le paramètre numérique est déterminé comme étant non défectueux et une plage numérique dans laquelle le paramètre numérique est déterminé comme étant défectueux.
